# EUROPEAN PATENT APPLICATION

(11) **EP 4 760 288 A1**
(43) Date of publication of application: **17.06.2026**
(21) Application number: 25307056.9
(22) Date of filing: 09.12.2025
(51) Int. Cl.: G01R 31/327

(54) **METHOD AND APPARATUS FOR MONITORING SWITCHING UNIT IN SOLID-STATE CIRCUIT BREAKER**

(30) Priority: 12.12.2024 CN 202411836065
(71) Applicant: SCHNEIDER ELECTRIC INDUSTRIES SAS, 92500 Rueil-Malmaison (FR)
(72) Inventor: LIU, Chenyang, SHANGHAI, 201203 (CN); ZHAO, Haijun, SHANGHAI, 201203 (CN); SHI, Ying, SHANGHAI, 201203 (CN); CHEN, Jiamin, SHANGHAI, 201203 (CN)
(74) Representative: Plasseraud IP

(57) **Abstract**

A switching unit includes a first group of power devices, a first and second electrodes of each power device are respectively electrically connected to a first and second nodes. A method for monitoring a switching unit in a solid-state circuit breaker includes: during a period in which a main circuit current flows from the first electrode to the second electrode in a first direction, causing a first turn-off voltage to be applied to a gate of each power device in a first time period; in response to the application of the first turn-off voltage, obtaining a voltage across a first capacitive element, where the first capacitive element and a first resistive element are connected in series between the first and second nodes; and based on the voltage across the first capacitive element, determining whether a turn-off function of each power device of the first group of power devices is normal.

## Description

### FIELD

Example embodiments of the present disclosure generally relate to the field of electrical equipment, and in particular to a method and an apparatus for monitoring a switching unit in a solid-state circuit breaker, a solid-state circuit breaker, and a computer-readable storage media.

### BACKGROUND

With the development of power systems and the increasing requirements for power reliability, solid-state circuit breakers (SSCBs), as a novel power control and protection device, have become increasingly prominent in importance. As a core component in the solid-state circuit breaker, a power device assumes a turn-off task in a case where a short circuit or other faults occur in a main circuit, so as to protect loads and cables from damage.

However, in practical applications, the power device may fail due to various reasons, which may not only cause the circuit breaker to fail to work normally, but also cause more serious power faults. Therefore, monitoring and diagnosing the health status of the power device in real time is of crucial importance for preventing faults and reducing potential losses.

Traditional power device detection method usually needs to be performed when the solid-state circuit breaker is in a shutdown state. Such detection method affects the continuity of power supply and contradicts the conventional requirements for working continuity of the circuit breaker.

### SUMMARY

Embodiments of the present disclosure provide a method and an apparatus for monitoring a switching unit in a solid-state circuit breaker, a solid-state circuit breaker, and a computer-readable storage medium.

In a first aspect of the present disclosure, a method of monitoring a switching unit in a solid-state circuit breaker is provided. The switching unit includes a first group of power devices, a first electrode of each power device of the first group of power devices is electrically connected to a first node, and a second electrode of each power device of the first group of power devices is electrically connected to a second node. The method includes: during a period in which a main circuit current flows from the first electrode to the second electrode of the first group of power devices in a first direction, causing a first turn-off voltage to be applied to a gate of each power device of the first group of power devices in a first time period; in response to the application of the first turn-off voltage, obtaining a voltage across a first capacitive element, where the first capacitive element and a first resistive element are connected in series between the first node and the second node; and based on the voltage across the first capacitive element, determining whether a turn-off function of each power device of the first group of power devices is normal when the main circuit current flows therethrough in the first direction.

In some embodiments, the determining whether the turn-off function of each power device of the first group of power devices is normal when the main circuit current flows therethrough in the first direction includes: in response to the voltage across the first capacitive element being higher than a first voltage threshold at a predetermined time point or within a predetermined time period after the first turn-off voltage starts to be applied, determining that the turn-off function of each power device of the first group of power devices is normal when the main circuit current flows therethrough in the first direction; and in response to the voltage across the first capacitive element being lower than the first voltage threshold at the predetermined time point or within the predetermined time period, determining that the turn-off function of at least one power device of the first group of power devices is abnormal when the main circuit current flows therethrough in the first direction.

In some embodiments, the method further includes: during a period in which a turn-on voltage is applied to the gate of each power device of the first group of power devices, obtaining a voltage between the first node and the second node; in response to the voltage between the first node and the second node being within a first predetermined voltage range, determining that a turn-on function of each power device of the first group of power devices is normal; and in response to the voltage between the first node and the second node being outside the first predetermined voltage range, determining the turn-on function of at least one power device of the first group of power devices is abnormal.

In some embodiments, the method further includes: during a period in which a turn-on voltage is applied to the gate of each power device of the first group of power devices, obtaining a first housing temperature of the first group of power devices; in response to the first housing temperature being within a first predetermined temperature range, determining that a turn-on function of each power device of the first group of power devices is normal; and in response to the first housing temperature being outside the first predetermined temperature range, determining that the turn-on function of at least one power device of the first group of power devices is abnormal.

In some embodiments, the switching unit further includes a second group of power devices, a first electrode of each power device of the second group of power devices is electrically connected to a third node, a second electrode of each power device of the second group of power devices is electrically connected to a fourth node, and the fourth node is electrically connected to the second node. A second capacitive element and a second resistive element are connected in series between the third node and the fourth node. The method further includes: during a period in which the main circuit current flows from the second electrode to the first electrode of the second group of power devices in the first direction, causing a second turn-off voltage to be applied to a gate of each power device of the second group of power devices in a second time period, where a length of the second time period is greater than that of the first time period; in response to the application of the second turn-off voltage, obtaining a voltage between the fourth node and the third node; and based on the voltage between the fourth node and the third node, determining whether a turn-off function of each power device of the second group of power devices is normal when the main circuit current flows therethrough in the first direction.

In some embodiments, the determining whether the turn-off function of each power device of the second group of power devices is normal when the main circuit current flows therethrough in the first direction includes: in response to the voltage between the fourth node and the third node being higher than a second voltage threshold after the second turn-off voltage is applied, determining that the turn-off function of each power device of the second group of power devices is normal when the main circuit current flows therethrough in the first direction; and in response to the voltage between the fourth node and the third node being lower than the second voltage threshold after the second turn-off voltage is applied, determining that the turn-off function of at least one power device of the second group of power devices is abnormal when the main circuit current flows therethrough in the first direction.

In some embodiments, the method further includes: obtaining a current value measured by a shunt resistor, the shunt resistor being electrically connected to the second node and the fourth node; obtaining a second housing temperature of the second group of power devices; and based on the current value and the second housing temperature, determining the second voltage threshold.

In some embodiments, the method further includes: during a period in which a turn-on voltage is applied to a gate of each power device of the first group of power devices and the second group of power devices, obtaining a voltage between the first node and the second node and a voltage between the fourth node and the third node; in response to the voltage between the first node and the second node being within a first predetermined voltage range, determining that a turn-on function of each power device of the first group of power devices is normal; in response to the voltage between the first node and the second node being outside the first predetermined voltage range, determining that the turn-on function of at least one power device of the first group of power devices is abnormal; in response to the voltage between the fourth node and the third node being within a second predetermined voltage range, determining that a turn-on function of each power device of the second group of power devices is normal; and in response to the voltage between the fourth node and the third node being outside the second predetermined voltage range, determining that the turn-on function of at least one power device of the second group of power devices is abnormal.

In some embodiments, the method further includes: during a period in which a turn-on voltage is applied to a gate of each power device of the first group of power devices and the second group of power devices, obtaining a first housing temperature of the first group of power devices and a second housing temperature of the second group of power devices; in response to the first housing temperature being within a first predetermined temperature range, determining that a turn-on function of each power device of the first group of power devices is normal; in response to the first housing temperature being outside the first predetermined temperature range, determining that the turn-on function of at least one power device of the first group of power devices is abnormal; in response to the second housing temperature being within a second predetermined temperature range, determining that a turn-on function of each power device of the second group of power devices is normal; and in response to the second housing temperature being outside the second predetermined temperature range, determining that the turn-on function of at least one power device of the second group of power devices is abnormal.

In some embodiments, the main circuit current is alternating current. The method further includes: during a period in which the main circuit current flows from the second electrode to the first electrode of the first group of power devices in a second direction, causing the first turn-off voltage to be applied to the gate of each power device of the first group of power devices in a third time period; in response to the application of the first turn-off voltage, obtaining a voltage between the first node and the second node; and based on the voltage between the first node and the second node, determining whether the turn-off function of each power device of the first group of power devices is normal when the main circuit current flows therethrough in the second direction.

In some embodiments, the method further includes: during a period in which the main circuit current flows from the first electrode to the second electrode of the second group of power devices in the second direction, causing the second turn-off voltage to be applied to the gate of each power device of the second group of power devices in a fourth time period; in response to the application of the second turn-off voltage, obtaining a voltage across the second capacitive element; and based on the voltage across the second capacitive element, determining whether the turn-off function of each power device of the second group of power devices is normal when the main circuit current flows therethrough in the second direction.

In some embodiments, the first time period corresponds to a first predetermined phase angle when the main circuit current flows in the first direction, the second time period corresponds to a second predetermined phase angle when the main circuit current flows in the first direction, the third time period corresponds to a third predetermined phase angle when the main circuit current flows in the second direction, and the fourth time period corresponds to a fourth predetermined phase angle when the main circuit current flows in the second direction.

In some embodiments, the method further includes: in response to the turn-off function or the turn-on function of at least one power device of the first group of power devices and the second group of power devices being abnormal, triggering an alarm or causing a mechanical switch of the solid-state circuit breaker to be opened.

In a second aspect of the present disclosure, an apparatus for monitoring a switching unit in a solid-state circuit breaker is provided. The apparatus includes: at least one processing unit; and at least one memory coupled to the at least one processing unit and storing instructions for execution by the at least one processing unit, the instructions, when executed by the at least one processing unit, causing the apparatus to perform the method according to the first aspect of the present disclosure.

In a third aspect of the present disclosure, a computer-readable storage medium is provided. The computer-readable storage medium has stored thereon a computer program executable by a processor to implement the method according to the first aspect of the present disclosure.

In a fourth aspect of the present disclosure, a solid-state circuit breaker is provided. The solid-state circuit breaker includes: a switching unit including a first group of power devices and a second group of power devices, where a first electrode of each power device of the first group of power devices is electrically connected to a first node, a second electrode of each power device of the first group of power devices is electrically connected to a second node, a first electrode of each power device of the second group of power devices is electrically connected to a third node, a second electrode of each power device of the second group of power devices is electrically connected to a fourth node, and the fourth node is electrically connected to the second node; a first capacitive element and a first resistive element connected in series between the first node and the second node; a second capacitive element and a second resistive element connected in series between the third node and the fourth node; a shunt resistor connected between the second node and the fourth node; and a processing unit configured to perform the method according to the first aspect of the present disclosure.

It will be understood from the following description that, in embodiments of the present disclosure, it is possible to monitor whether the switching unit can be normally turned off during operation of the solid-state circuit breaker without shutting down the solid-state circuit breaker, thereby avoiding a situation that the switching unit cannot be turned off when a short circuit occurs in the main circuit due to failure of the power device. Other benefits will be described below in conjunction with corresponding embodiments.

It should be understood that the content described in this content section is not intended to limit the key features or important features of embodiments of the present disclosure, nor is it intended to limit the scope of the present disclosure. Other features of the present disclosure will become readily understood through the following description.

### BRIEF DESCRIPTION OF DRAWINGS

The above and other features, advantages, and aspects of various embodiments of the present disclosure will become more apparent from the following detailed description taken in conjunction with the accompanying drawings. In the drawings, the same or similar reference numbers refer to the same or similar elements, wherein:
FIG. 1 shows a schematic diagram of an example environment in which embodiments of the present disclosure can be implemented;
FIG. 2 shows a schematic structural diagram of a monitoring apparatus according to some embodiments of the present disclosure;
FIG. 3 shows a flowchart of a process of monitoring a switching unit according to some embodiments of the present disclosure;
FIG. 4 shows a timing diagram of various signals in a case where a main circuit current is direct current flowing through a first group of power devices in a first direction, and a first turn-off voltage is applied to a gate of the first group of power devices in a first time period, according to some embodiments of the present disclosure;
FIG. 5 shows a flowchart of a process of monitoring a turn-off function of a first group of power devices in a case where a main circuit current is direct current flowing through a first group of power devices in a first direction, according to some embodiments of the present disclosure;
FIG. 6 shows a flowchart of a process of monitoring a turn-off function of a second group of power devices in a case where a main circuit current is direct current flowing through a second group of power devices in a first direction, according to some embodiments of the present disclosure;
FIG. 7 shows a timing diagram of various signals in a case where a main circuit current is direct current flowing through a second group of power devices in a first direction, and a second turn-off voltage is applied to a gate of the second group of power devices in a second time period, according to some embodiments of the present disclosure;
FIG. 8 shows a flowchart of a process of monitoring turn-on functions of a first group of power devices and a second group of power devices in a case where a main circuit current is direct current according to some embodiments of the present disclosure;
FIG. 9 shows a flowchart of a process of monitoring turn-on functions of a first group of power devices and a second group of power devices in a case where a main circuit current is direct current according to some other embodiments of the present disclosure;
FIG. 10 shows a flowchart of a process of monitoring a turn-off function of a first group of power devices during a period in which a main circuit current is alternating current and flows in a first direction, according to some embodiments of the present disclosure;
FIG. 11 shows a timing diagram of various signals in a case where a first turn-off voltage is applied to a first group of power devices during a period in which a main circuit current is alternating current and flows in a first direction, according to some embodiments of the present disclosure;
FIG. 12 shows a flowchart of a process of monitoring a turn-off function of a second group of power devices during a period in which a main circuit current is alternating current and flows in a first direction, according to some embodiments of the present disclosure;
FIG. 13 shows a timing diagram of various signals in a case where a second turn-off voltage is applied to a second group of power devices during a period in which a main circuit current is alternating current and flows in a first direction, according to some embodiments of the present disclosure; and
FIG. 14 shows a block diagram of a device capable of implementing various embodiments of the present disclosure.

### DETAILED DESCRIPTION

Embodiments of the present disclosure will be described in more detail below with reference to the accompanying drawings. While certain embodiments of the present disclosure are shown in the accompanying drawings, it should be understood that the present disclosure may be implemented in various forms, and should not be construed as limited to embodiments set forth herein, but rather, these embodiments are provided for a more thorough and complete understanding of the present disclosure. It should be understood that the drawings and embodiments of the present disclosure are for illustrative purposes only and are not intended to limit the scope of the present disclosure.

In the description of embodiments of the present disclosure, the terms "including" and the like should be understood as open-ended inclusion, i.e., "including but not limited to". The term "based on" should be understood as "based at least in part on". The terms "an embodiment" or "the embodiment" should be understood as "at least one embodiment". The term "some embodiments" should be understood as "at least some embodiments". Other explicit and implicit definitions may also be included below. The terms "first", "second", and the like may refer to different or identical objects. Other explicit and implicit definitions may also be included below.

As briefly mentioned above, a traditional method of detecting a power device of a solid-state circuit breaker usually needs to be performed when the solid-state circuit breaker is in a shutdown state. Such detection method affects the continuity of power supply and contradicts the conventional requirements for working continuity of the circuit breaker.

To this end, embodiments of the present disclosure provide a solution for monitoring a switching unit in a solid-state circuit breaker. According to various embodiments of the present disclosure, it is possible to monitor whether the switching unit can be normally turned off during operation of the solid-state circuit breaker without shutting down the solid-state circuit breaker, thereby avoiding a situation that the switching unit cannot be turned off when a short circuit occurs in a main circuit due to failure of the power device.

Some example embodiments of the present disclosure will be described below with reference to the accompanying drawings. It should be noted that, in several descriptions of embodiments, in order to better assist readers in understanding, certain specific values may be involved. These values are illustrative and may vary according to a specific application scenario and do not limit the scope of the present disclosure in any way.

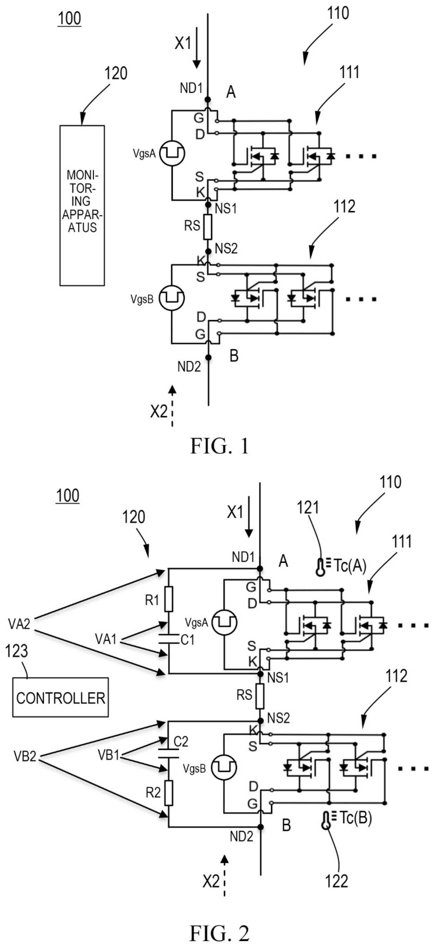

FIG. 1 shows a schematic diagram of an example environment 100 in which embodiments of the present disclosure can be implemented. The environment 100 includes a switching unit 110 that is a part of a solid-state circuit breaker. The switching unit 110 may be connected to a main circuit (not shown) and is used to be turned off in a case where a short circuit or other faults occur in the main circuit, thereby protecting loads and cables from damage. In some embodiments, the switching unit 110 may include a first group of power devices 111 and a second group of power devices 112. The first group of power devices 111 may include one or more power devices and may be referred to herein as an A-side power device or an A-side device. A first electrode of each power device of the first group of power devices 111 is electrically connected to a first node ND1, and a second electrode of each power device of the first group of power devices 111 is electrically connected to a second node NS1. In a case where the first group of power devices 111 includes a plurality of power devices, these power devices are connected in parallel between the first node ND1 and the second node NS1. Similarly, the second group of power devices 112 may include one or more power devices and may be referred to herein as a B-side power device or a B-side device. The second group of power devices 112 and the first group of power devices 111 may have the same or different number of devices. A first electrode of each power device of the second group of power devices 112 is electrically connected to a third node ND2, and a second electrode of each power device of the second group of power devices 112 is electrically connected to a fourth node NS2. In a case where the second group of power devices 112 includes a plurality of power devices, these power devices are connected in parallel between the third node ND2 and the fourth node NS2. The fourth node NS2 is electrically connected to the second node NS1, such that the first group of power devices 111 and the second group of power devices 112 are connected in anti-series. A turn-on/off state of each power device of the first group of power devices 111 and the second group of power devices 112 may be controlled by a voltage applied to its gate. With this arrangement, the switching unit 110 may achieve a bidirectional turn-off function. The first node ND1 and the third node ND2 are electrically connected to the main circuit.

In some embodiments, the power devices of the second group of power devices 112 and the first group of power devices 111 may be silicon carbide metal-oxide-semiconductor field-effect transistors (SiC MOSFETs). In a case where the power devices of the second group of power devices 112 and the first group of power devices 111 are SiC MOSFETs, the first electrode is drain D and the second electrode is source S. The principles of the present disclosure will be described below by taking SiC MOSFETs as examples of the power devices. However, it should be understood that the power devices of the second group of power devices 112 and the first group of power devices 111 may be of other types, and embodiments of the present disclosure are not limited thereto. As an example, each power device of the second group of power devices 112 and the first group of power devices 111 may include an insulated gate bipolar transistor (IGBT) and a diode connected in parallel. In such an example, the first electrode is a collector and the second electrode is an emitter. Embodiments of the present disclosure are also applicable to monitoring whether a turn-off function and a turn-on function of the IGBT are normal.

In a case where the main circuit current is normal, a drive voltage VgsA applied to a gate G of the first group of power devices 111 and a drive voltage VgsB applied to a gate G of the second group of power devices 112 remain at a turn-on voltage, so that each power device remains conducting. In a case where a short circuit or other faults occur in the main circuit, the drive voltage VgsA or the drive voltage VgsB may be switched to a turn-off voltage to cut off the main circuit. The main circuit current may be referred to herein as a load current.

Since the first group of power devices 111 and the second group of power devices 112 are connected in anti-series, the switching unit 110 may achieve a bidirectional turn-off function. Specifically, in a case where the main circuit current flows through the switching unit 110 in a first direction X1 and a short circuit or other faults occur in the main circuit, the drive voltage VgsA may be switched to the turn-off voltage, so that each power device of the first group of power devices 111 is switched to a turn-off state, thereby cutting off the main circuit current. Similarly, in a case where the main circuit current flows through the switching unit 110 in a second direction X2 opposite to the first direction X1 and a short circuit or other faults occur in the main circuit, the drive voltage VgsB may be switched to the turn-off voltage, so that each power device of the second group of power devices 112 is switched to a turn-off state, thereby cutting off the main circuit current. Since the switching unit 110 can achieve the bidirectional turn-off function, the solid-state circuit breaker including the switching unit 110 can be applied to a DC or AC scenario.

As shown in FIG. 1, in order to monitor a state of the switching unit 110, the environment 100 may further include a monitoring apparatus 120. The monitoring apparatus 120 may monitor whether a turn-on function and/or a turn-off function of the switching unit 110 is normal without shutting down the solid-state circuit breaker, so as to timely detect a fault occurring in the switching unit 110 while ensuring continuity of the power supply, which will be described in detail hereinafter.

FIG. 2 shows a schematic structural diagram of a monitoring apparatus 120 according to some embodiments of the present disclosure.

In some embodiments, as shown in FIG. 2, the monitoring apparatus 120 may include a first capacitive element C1, a first resistive element R1, a second capacitive element C2, and a second resistive element R2. The first capacitive element C1 and the first resistive element R1 are connected in series between the first node ND1 and the second node NS1. The second capacitive element C2 and the second resistive element R2 are connected in series between the third node ND2 and the fourth node NS2.

In some embodiments, as shown in FIG. 2, the first resistive element R1 is connected to the first node ND1, the first capacitive element C1 is connected to the second node NS1, the second capacitive element C2 is connected to the fourth node NS2, and the second resistive element R2 is connected to the third node ND2. It should be understood that the positions of the first capacitive element C1 and the first resistive element R1 may be interchanged, and the positions of the second capacitive element C2 and the second resistive element R2 may be interchanged. In addition, each capacitive element of the first capacitive element C1 and the second capacitive element C2 may include a single capacitor or a plurality of sub-capacitors connected in parallel. Similarly, each resistive element of the first resistive element R1 and the second resistive element R2 may include a single resistor or a plurality of sub-resistors connected in series.

In some embodiments, by monitoring one or more items of a voltage VA1 across the first capacitive element C1, a voltage VA2 between the first node ND1 and the second node NS1, a voltage VB1 across the second capacitive element C2, and a voltage VB2 between the fourth node NS2 and the third node ND2, whether the turn-off function or the turn-on function of the power device of the first group of power devices 111 and the second group of power devices 112 is normal may be determined, which will be described in detail below.

In some embodiments, the switching unit 110 may include only the first group of power devices 111 or the second group of power devices 112. Such a switching unit 110 may be used in a DC scenario to achieve a unidirectional turn-off function. Correspondingly, in a case where the switching unit 110 includes only the first group of power devices 111, the monitoring apparatus 120 includes the first capacitive element C1 and the first resistive element R1. In a case where the switching unit 110 includes only the second group of power devices 112, the monitoring apparatus 120 includes the second capacitive element C2 and the second resistive element R2.

In some embodiments, as shown in FIG. 2, the monitoring apparatus 120 may further include a shunt resistor RS electrically connected between the second node NS1 and the fourth node NS2 to measure a current value Ishunt.

In some embodiments, as shown in FIG. 2, the monitoring apparatus 120 may further include a first temperature sensor 121 and a second temperature sensor 122. The first temperature sensor 121 is used to detect a first housing temperature Tc (A) of the first group of power devices 111. In a case where the turn-on function of the first group of power devices 111 is normal, the first housing temperature Tc (A) will be within a first predetermined temperature range. In a case where the turn-on function of the first group of power devices 111 is abnormal, the first housing temperature Tc (A) will be outside the first predetermined temperature range. The second temperature sensor 122 is used to detect a second housing temperature Tc (B) of the second group of power devices 112. In a case where the turn-on function of the second group of power devices 112 is normal, the second housing temperature Tc (B) will be within a second predetermined temperature range. In a case where the turn-on function of the second group of power devices 112 is abnormal, the second housing temperature Tc (B) will be outside the second predetermined temperature range. Depending on the device type and the number of device of the first group of power devices 111 and the second group of power devices 112, the first predetermined temperature range and the second predetermined temperature range may be the same as or different from each other, which may be predetermined according to design requirements. In addition, the first temperature sensor 121 and the second temperature sensor 122 may be thermocouples or any other suitable type, and embodiments of the present disclosure are not limited thereto.

In some embodiments, as shown in FIG. 2, the monitoring apparatus 120 may further include a controller 123. The controller 123 may determine whether the turn-on function and/or the turn-off function of the switching unit 110 is normal based on one or more items of the voltage VA1, the voltage VA2, the voltage VB1, the voltage VB2, the current value Ishunt, the housing temperature Tc (A), and the housing temperature Tc (B). Next, an example process of monitoring the turn-off function and/or the turn-on function of the switching unit in the solid-state circuit breaker will be described in conjunction with FIGS. 1-14.

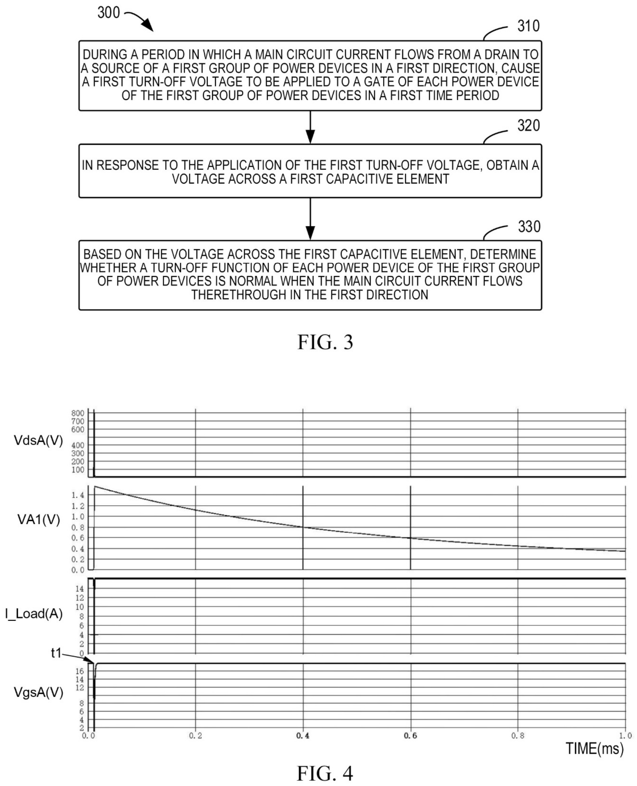

FIG. 3 shows a flowchart of a process 300 of monitoring the switching unit according to some embodiments of the present disclosure. The process 300 may be performed by the monitoring apparatus 120 or the controller 123 to determine whether the turn-off function of each power device of the first group of power devices 111 is normal when the main circuit current flows therethrough in the first direction X1. The main circuit current may be direct current or alternating current.

At block 310, during a period in which the main circuit current flows from the drain D to the source S of the first group of power devices 111 in the first direction X1, a first turn-off voltage is applied to the gate G of each power device of the first group of power devices 111 in a first time period. During the first time period, since the first turn-off voltage is applied to the gate G of the first group of power devices 111, in a case where the turn-off function of the first group of power devices 111 is normal, the channel of the first group of power devices 111 will be cut off and the body diode of the first group of power devices 111 cannot conduct, thus the first group of power devices 111 is in a turn-off state, thereby cutting off a current path of the main circuit current. In order to make the cutting off of the current path not affect the normal operation of a load connected to the main circuit, the cutting off time should be as short as possible, such as on the order of microseconds (µs). As an example, the first time period may be within a range of 1 µs to 2 µs. It should be understood that the first time period may be set accordingly, e.g., be higher or lower, depending on the type of load connected to the main circuit.

Herein, a description is provided by taking the main circuit current I_Load as direct current as an example. FIG. 4 shows a timing diagram of various signals in a case where the main circuit current I_Load is direct current flowing through the first group of power devices 111 in the first direction X1, and the first turn-off voltage is applied to the gate G of the first group of power devices 111 in a first time period. The shown signals include the drive voltage VgsA applied to the gate G of the first group of power devices 111, the main circuit current I_Load, the voltage VA1 across the first capacitive element C1, and a drain-source voltage VdsA between the drain D and the source S of the first group of power devices 111.

As shown in FIG. 4, in a case where the drive voltage VgsA is changed to the first turn-off voltage (for example, drops to 0V) in the first time period t1, since the first group of power devices 111 is in the turn-off state, the main circuit current I_Load will be cut off accordingly, and the drain-source voltage VdsA will rise significantly. However, the duration for the drain-source voltage VdsA to rise is relatively short, substantially corresponding to the first time period t1. In such a short time, a change of the drain-source voltage VdsA is difficult to be captured. To this end, in embodiments of the present disclosure, the first capacitive element C1 and the first resistive element R1 connected in series are provided between the first node ND1 and the second node NS1, as described above with reference to FIGS. 1 and 2.

As shown in FIG. 4, in the case where the drive voltage VgsA is changed to the first turn-off voltage in the first time period t1, the voltage VA1 across the first capacitive element C1 rises instantaneously (for example, rises to about 1.6V). Since the first resistive element R1 and the first capacitive element C1 are connected in series, such that the voltage VA1 can drop relatively slowly, there is a sufficient time to capture the change of the voltage VA1. For example, as shown in FIG. 4, the voltage VA1 can be maintained for more than 1 milliseconds (ms).

At block 320, in response to the application of the first turn-off voltage, the voltage VA1 across the first capacitive element C1 is obtained. In a case where the first turn-off voltage is applied to the gate G of the first group of power devices 111 in the first time period t1, since the voltage VA1 rises instantaneously and drops relatively slowly, there is a sufficient time to capture the change of the voltage VA1, which can therefore be reliably obtained by the controller 123. Therefore, the change of the voltage VA1 can be accurately captured.

At block 330, based on the voltage VA1 across the first capacitive element C1, it is determined whether the turn-off function of each power device of the first group of power devices 111 is normal when the main circuit current flows therethrough in the first direction X1. The change of the voltage VA1 can reflect whether the first group of power devices 111 is normally turned off. Therefore, it is possible to determine whether the turn-off function in the first direction X1 is normal based on the voltage VA1.

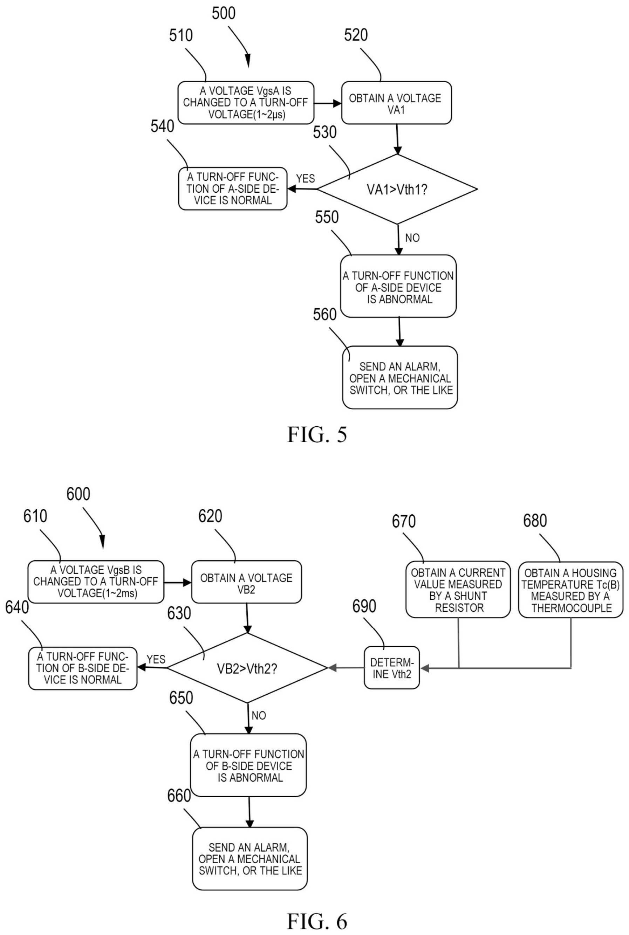

FIG. 5 shows a flowchart of a process 500 of monitoring the turn-off function of the first group of power devices in a case where the main circuit current is direct current flowing through the first group of power devices in the first direction. The process 500 may be performed by the monitoring apparatus 120 or the controller 123 to determine whether the turn-off function of each power device of the first group of power devices 111 is normal when the direct current flows therethrough in the first direction X1.

At block 510, during a period in which the main circuit current (DC) flows from the drain D to the source S of the first group of power devices 111 in the first direction X1, the voltage VgsA is changed to the first turn-off voltage in the first time period t1 of, for example, 1 µs to 2 µs, so as to turn off the first group of power devices 111 in the first time period t1.

At block 520, in response to the application of the first turn-off voltage, the voltage VA1 across the first capacitive element C1 is obtained. As described above, since the voltage VA1 rises instantaneously and drops relatively slowly, thus there is a sufficient time to capture the change of the voltage VA1.

At block 530, it is determined whether the voltage VA1 is greater than the first voltage threshold Vth1. The first voltage threshold Vth1 may be predetermined according to the device type and other design requirements. For example, the first voltage threshold Vth1 may be set to be 0.3V in a case where the voltage VA1 instantaneously rises to more than 1.4V as shown in FIG. 4 and slowly drops to slightly below 0.4V within 1ms.

At block 540, in response to the voltage VA1 being higher than the first voltage threshold Vth1 at a predetermined time point or within a predetermined time period after the first turn-off voltage starts to be applied, it is determined that the turn-off function of each power device of the first group of power devices 111 is normal when the main circuit current flows therethrough in the first direction X1. Since the voltage VA1 rises instantaneously and drops relatively slowly, a value of the voltage VA1 at the predetermined time point or within the predetermined time period after the first turn-off voltage starts to be applied can be used as an evaluation criterion, so as to diagnose the turn-off function of the first group of power devices 111. If the value of the voltage VA1 is higher than the threshold Vth1, it indicates that the first group of power devices 111 can be reliably turned off.

At block 550, in response to the voltage VA1 being lower than the first voltage threshold Vth1 at the predetermined time point or within the predetermined time period, it is determined that the turn-off function of at least one power device of the first group of power devices 111 is abnormal when the main circuit current flows therethrough in the first direction X1. If the value of the voltage VA1 is lower than the threshold Vth1, it is indicated that at least one power device of the first group of power devices 111 fails to be reliably turned off.

At block 560, in response to the turn-off function of at least one power device of the first group of power devices 111 being abnormal, an alarm is triggered or a mechanical switch of the solid-state circuit breaker is caused to be opened for timely maintenance. The alarm may adopt any suitable manner such as sound, light, or electricity, and embodiments of the present disclosure are not limited thereto.

Next, a process 600 of monitoring the turn-off function of the second group of power devices in a case where the main circuit current is direct current flowing through the second group of power devices in the first direction will be described in conjunction with FIGS. 2 and 6. The process 600 may be performed by the monitoring apparatus 120 or the controller 123 to determine whether the turn-off function of each power device of the second group of power devices 112 is normal when the direct current flows therethrough in the first direction X1.

At block 610, during a period in which the main circuit current (DC) flows from the source S to the drain D of the second group of power devices 112 in the first direction X1, the second turn-off voltage is caused to be applied to a gate G of each power device of the second group of power devices 112 (B-side device) in a second time period t2. A length of the second time period t2 is greater than that of the first time period t1. As an example, the second time period t2 may be within a range of 1ms to 2ms. It should be understood that the second time period t2 may be set accordingly, e.g., be higher or lower, depending on the type of load connected to the main circuit. Depending on the specification of the device, the second turn-off voltage may be the same as or different from the first turn-off voltage.

As shown in FIG. 2, in a case where the turn-off function of the second group of power devices 112 is normal, if the second turn-off voltage is applied to the gate G of the second group of power devices 112, the channel of the second group of power devices 112 will be cut off, but the main circuit current can flow through the body diode of the second group of power devices 112. Thus, the main circuit current is not affected.

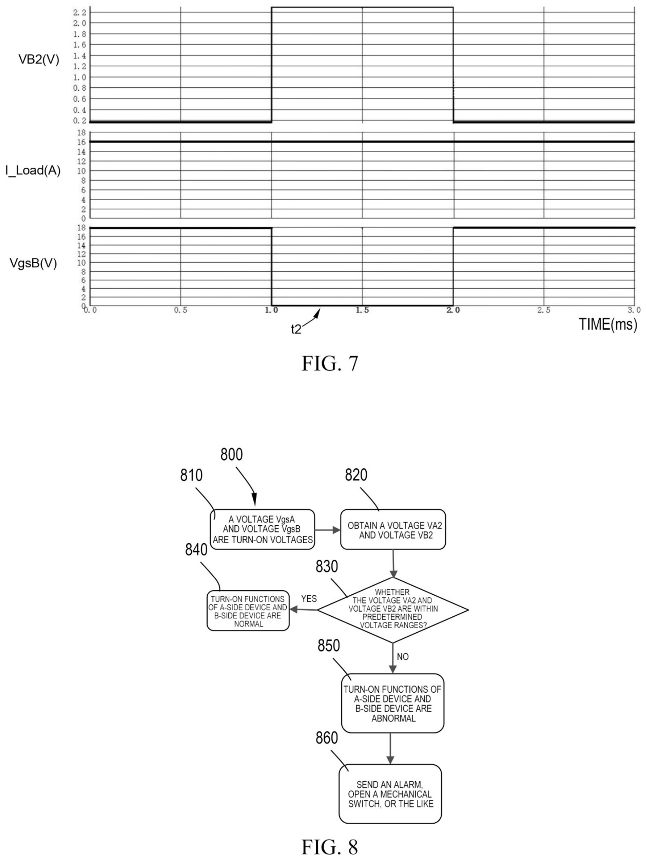

FIG. 7 shows a timing diagram of various signals in a case where the main circuit current is direct current flowing through the second group of power devices in the first direction, and the second turn-off voltage is applied to the gate of the second group of power devices in a second time period. The shown signals include a drive voltage VgsB applied to the gate G of the second group of power devices 112, the main circuit current I_Load, and the voltage VB2 between the fourth node NS2 and the third node ND2.

As shown in FIG. 7, in a case where the drive voltage VgsB is changed to the second turn-off voltage (for example, drops to 0V) in a second time period t2, the main circuit current I_Load is not affected, and thus the normal operation of the load is not affected. The voltage VB2 may rise significantly in the case where the drive voltage VgsB is changed to the second turn-off voltage, and a lasting time of the rising voltage VB2 substantially corresponds to the second time period t2. A relatively long turn-off time of the second group of power devices 112 facilitates capturing the change of the voltage VB2. As an example, the second time period t2 may be on the order of milliseconds (ms), for example, 1ms to 2ms.

At block 620, in response to the application of the second turn-off voltage, the voltage VB2 between the fourth node NS2 and the third node ND2 is obtained. As described above, since the turn-off of the second group of power devices 112 does not affect the main circuit current, the second time period t2 may be set to be relatively long, so that there is a sufficient time to capture the change of the voltage VB2.

Subsequently, based on the voltage VB2, it may be determined whether the turn-off function of each power device of the second group of power devices 112 is normal when the main circuit current flows therethrough in the first direction X1. For example, whether the turn-off function of the second group of power devices 112 is normal may be determined through the acts of blocks 630, 640, and 650.

At block 630, it is determined whether the voltage VB2 is greater than a second voltage threshold Vth2. The second voltage threshold Vth2 may be predetermined according to the device type and other design requirements. For example, in a case where the voltage VB2 can rise to more than 2.2V as shown in FIG. 7, the second voltage threshold Vth2 can be set to be 1.8V. In some embodiments, the second voltage threshold Vth2 may be predetermined. In other embodiments, the second voltage threshold Vth2 may be dynamically determined as described below in conjunction with blocks 670, 680, and 690.

At block 640, in response to the voltage VB2 between the fourth node NS2 and the third node ND2 being higher than the second voltage threshold Vth2 after the second turn-off voltage is applied, it is determined that the turn-off function of each power device of the second group of power devices 112 is normal when the main circuit current flows therethrough in the first direction X1. Since the rising voltage VB2 can last for a relatively long time, a value of the voltage VB2 may be used as an evaluation criterion, so as to diagnose the turn-off function of the second group of power devices 112. If the value of the voltage VB2 is higher than the threshold Vth2, it indicates that the second group of power devices 112 can be reliably turned off.

At block 650, in response to the voltage VB2 between the fourth node NS2 and the third node ND2 being lower than the second voltage threshold Vth2 after the second turn-off voltage is applied, it is determined that the turn-off function of at least one power device of the second group of power devices 112 is abnormal when the main circuit current flows therethrough in the first direction X1. If the value of the voltage VB2 is lower than the threshold Vth2, it is indicated that at least one device of the second group of power devices 112 fails to be reliably turned off.

At block 660, in response to the turn-off-function of at least one power device of the second group of power devices 112 being abnormal, the alarm is triggered or the mechanical switch of the solid-state circuit breaker is caused to be opened for timely maintenance.

At block 670, a current value Ishunt measured by the shunt resistance RS is obtained.

At block 680, a second housing temperature Tc (B) of the second group of power devices 112 is obtained.

At block 690, based on the current value Ishunt and the second housing temperature Tc (B), the second voltage threshold Vth2 is determined. Since an impedance of a body diode is related to a magnitude of the current flowing therethrough and the temperature, it is possible to more accurately determine whether the turn-off function of the device is normal through dynamically determining the second voltage threshold Vth2.

Returning to FIG. 2, in a case where the main circuit current is direct current and flows through the first group of power devices 111 and the second group of power devices 112 in the second direction X2, the monitoring process of the turn-off functions of the first group of power devices 111 and the second group of power devices 112 is similar to the process described in conjunction with FIGS. 5 to 7.

In some embodiments, in a case where the main circuit current is direct current and flows through the first group of power devices 111 in the second direction X2, in order to monitor whether the turn-off function of the first group of power devices 111 is normal, the first turn-off voltage may be applied to the gate G of each power device of the first group of power devices 111 in a third time period t3. In response to the application of the first turn-off voltage, the voltage VA2 between the first node ND1 and the second node NS1 may be obtained. Then, it may be determined, based on the voltage VA2 between the first node ND1 and the second node NS1, whether the turn-off function of each power device of the first group of power devices 111 is normal when the main circuit current flows therethrough in the second direction X2. This process is similar to the process of monitoring whether the turn-off function of the second group of power devices 112 is normal in the case where the main circuit current flows through the second group of power devices 112 in the first direction X1.

In some embodiments, in a case where the main circuit current is direct current and flows through the second group of power devices 112 in the second direction X2, in order to monitor whether the turn-off function of the second group of power devices 112 is normal, the second turn-off voltage may be applied to the gate G of each power device of the second group of power devices 112 in a fourth time period t4. In response to the application of the second turn-off voltage, the voltage VB1 across the second capacitive element C2 may be obtained. Then, based on the voltage VB1 across the second capacitive element C2, it can be determined whether the turn-off function of each power device of the second group of power devices 112 is normal when the main circuit current flows therethrough in the second direction X2. This process is similar to the process of monitoring whether the turn-off function of the first group of power devices 111 is normal in the case where the main circuit current flows through the first group of power devices 111 in the first direction X1.

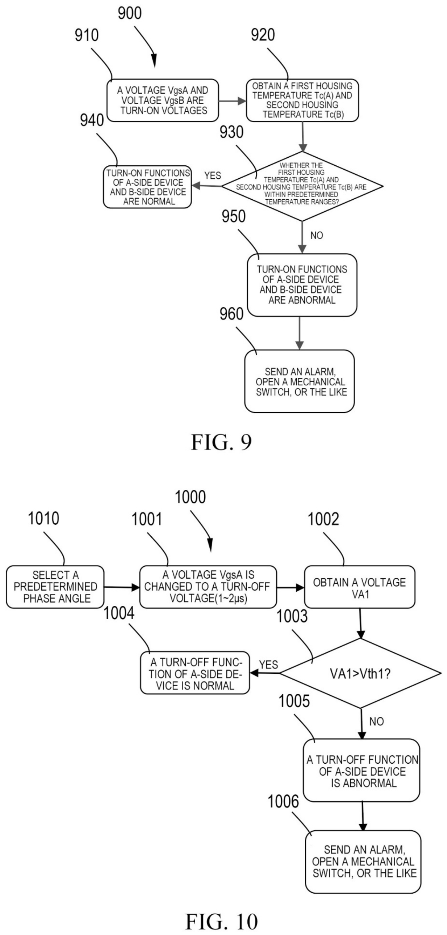

Next, a process of monitoring whether the turn-on functions of the first group of power devices 111 and the second group of power devices 112 are normal in the case where the main circuit current is direct current will be described in conjunction with FIGS. 8 and 9. The monitoring processes for the turn-on function are the same when the main circuit current flows in the first direction X1 and the second direction X2.

FIG. 8 shows a flowchart of a process 800 of monitoring the turn-on function of the device.

At block 810, the turn-on voltage is applied to the gate G of each power device of the first group of power devices 111 and the second group of power devices 112. In other words, the drive voltage VgsA and the drive voltage VgsB are maintained at the turn-on voltage.

At block 820, the voltage VA2 between the first node ND1 and the second node NS1 is obtained, and the voltage VB2 between the fourth node NS2 and the third node ND2 is obtained.

At block 830, it is determined whether the voltage VA2 and the voltage VB2 are within predetermined voltage ranges. For example, it may be determined whether the voltage VA2 is within a first predetermined voltage range, and whether the voltage VB2 is within a second predetermined voltage range. The first predetermined voltage range and the second predetermined voltage range may be the same or different, depending on the device type and design requirements.

At block 840, in response to the voltage VA2 and the voltage VB2 being within the predetermined voltage ranges, it is determined that the turn-on functions of the first group of power devices 111 and the second group of power devices 112 are normal. Specifically, in response to the voltage VA2 being within the first predetermined voltage range, it is determined that the turn-on function of each power device of the first group of power devices 111 is normal. In response to the voltage VB2 being within the second predetermined voltage range, it is determined that the turn-on function of each power device of the second group of power devices 112 is normal.

At block 850, in response to the voltage VA2 and the voltage VB2 being outside the predetermined voltage ranges, it is determined that the turn-on function of at least one power device of the first group of power devices 111 and the second group of power devices 112 is abnormal. Specifically, in response to the voltage VA2 being outside the first predetermined voltage range, it may be determined that the turn-on function of the at least one power device of the first group of power devices 111 is abnormal. In response to the voltage VB2 being outside the second predetermined voltage range, it may be determined that the turn-on function of the at least one power device of the second group of power devices 112 is abnormal.

At block 860, in response to determining that the turn-on function of the at least one power device of the first group of power devices 111 and the second group of power devices 112 is abnormal, the alarm may be triggered or the mechanical switch of the solid-state breaker is caused to be opened for timely maintenance.

FIG. 9 shows a flowchart of a process 900 of monitoring the turn-on function of the device.

At block 910, the turn-on voltage is applied to the gate G of each power device of the first group of power devices 111 and the second group of power devices 112.

At block 920, the first housing temperature Tc (A) of the first group of power devices 111 is obtained, and the second housing temperature Tc (B) of the second group of power devices 112 is obtained.

At block 930, it is determined whether the first housing temperature Tc (A) and the second housing temperature Tc (B) are within predetermined temperature ranges. For example, it may be determined whether the first housing temperature Tc (A) is within the first predetermined temperature range, and whether the second housing temperature Tc (B) is within the second predetermined temperature range. The first predetermined temperature range and the second predetermined temperature range may be the same or different, depending on the device type and design requirements.

At block 940, in response to the first housing temperature Tc (A) and the second housing temperature Tc (B) being within the predetermined temperature ranges, it is determined that the turn-on functions of the first group of power devices 111 and the second group of power devices 112 are normal. Specifically, in response to the first housing temperature Tc (A) being within the first predetermined temperature range, it is determined that the turn-on function of each power device of the first group of power devices 111 is normal. In response to the second housing temperature Tc (B) being within the second predetermined temperature range, it is determined that the turn-on function of each power device of the second group of power devices 112 is normal.

At block 950, in response to the first housing temperature Tc (A) and the second housing temperature Tc (B) being outside the predetermined temperature ranges, it is determined that the turn-on function of at least one power device of the first group of power devices 111 and the second group of power devices 112 is abnormal. Specifically, in response to the first housing temperature Tc (A) being outside the first predetermined temperature range, it may be determined that the turn-on function of the at least one power device of the first group of power devices 111 is abnormal. In response to the second housing temperature Tc (B) being outside the second predetermined temperature range, it may be determined that the turn-on function of at least one power device of the second group of power devices 112 is abnormal.

At block 960, in response to determining that the turn-on function of the at least one power device of the first group of power devices 111 and the second group of power devices 112 is abnormal, the alarm may be triggered or the mechanical switch of the solid-state breaker may be caused to be opened for timely maintenance.

Although the diagnosis process of the turn-on function is described separately above with respect to the drain-source voltage and the housing temperature, it should be understood that whether the turn-on functions of the first group of power devices 111 and the second group of power devices 112 are normal may be determined in combination with the voltage VA2, the voltage VB2, the first housing temperature Tc (A), and the second housing temperature Tc (B), which will not be repeated here.

As described above, the switching unit 110 may include only the first group of power devices 111 or the second group of power devices 112, such that the switching unit 110 may be used in a DC scenario to achieve a unidirectional turn-off function. In this case, the monitoring process for the turn-on function and the turn-off function of the first group of power devices 111 or the second group of power devices 112 described above is also applicable, which will not be repeated here.

In addition, as described above, the solid-state circuit breaker including the switching unit 110 may be applied to a DC or AC scenario. Next, a diagnostic process of the turn-off function and turn-on function of the solid-state circuit breaker applied in the AC scenario will be described.

FIG. 10 shows a flowchart of a process 1000 of monitoring the turn-off function of the first group of power devices during a period in which the main circuit current is alternating current and flows in the first direction, according to some embodiments of the present disclosure. The process 1000 may be performed by the monitoring apparatus 120 or the controller 123. The process 1000 is similar to process 500 except that a predetermined phase angle needs to be selected in order to select an appropriate first time period t1. Hereinafter, the difference between the process 1000 and the process 500 will be mainly described, and the same parts will not be repeated here.

At block 1010, a first predetermined phase angle is selected, and the first predetermined phase angle corresponds to the first time period t1. In some embodiments, the first predetermined phase angle may be selected within a range of (1/100) * π to (99/100) * π. In other embodiments, the first predetermined phase angle may be selected within a range of (7/200) * π to (243/250) * π.

At block 1001, during a period in which the main circuit current (AC) flows from the drain D to the source S of the first group of power devices 111 in the first direction X1, the voltage VgsA is changed to the first turn-off voltage in the first time period t1 (e.g., 1 µs to 2 µs) corresponding to the first predetermined phase angle, so as to turn off the first group of power devices 111 in this time period.

The process shown in blocks 1002 to 1006 is similar to the process of blocks 520 to 560 described in conjunction with FIG. 5, and details will not be repeated here.

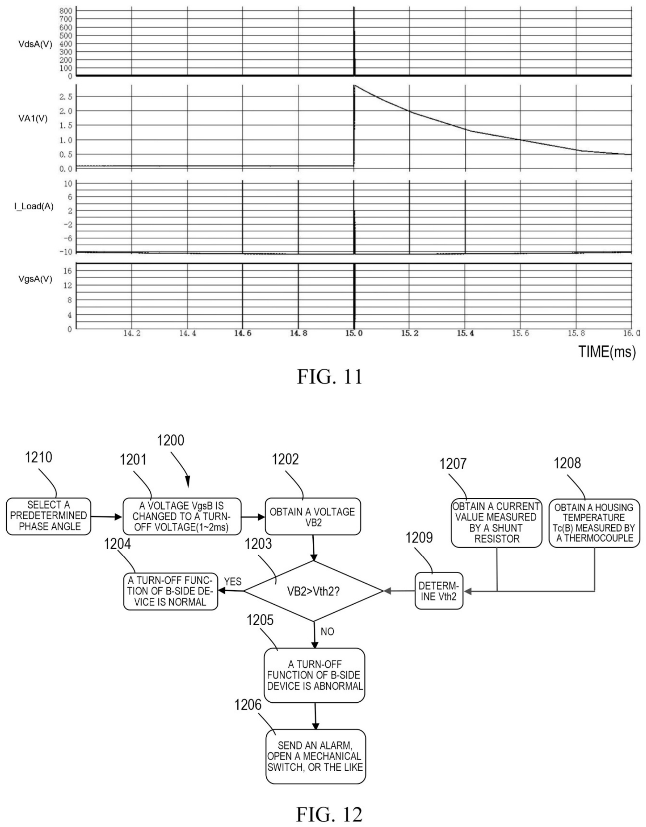

FIG. 11 shows a timing diagram of various signals in a case where the first turn-off voltage is applied to the first group of power devices during a period in which the main circuit current is alternating current and flows in the first direction, according to some embodiments of the present disclosure. The shown signals include the drive voltage VgsA applied to the gate G of the first group of power devices 111, the main circuit current I_Load, the voltage VA1 across the first capacitive element C1, and the drain-source voltage VdsA between the drain D and the source S of the first group of power devices 111.

As shown in FIG. 11, in a case where the drive voltage VgsA is changed to the first turn-off voltage (for example, drops to 0V) in the first time period t1 corresponding to the first predetermined phase angle, the main circuit current I_Load is correspondingly cut off, the drain-source voltage VdsA rises significantly, and the voltage VA1 across the first capacitive element C1 rises instantaneously. Since the first resistive element R1 and the first capacitive element C1 are connected in series, so that the voltage VA1 can drop relatively slowly, there is a sufficient time to capture the change of the voltage VA1 so as to be reliably obtained by the controller 123. For example, as shown in FIG. 11, the voltage VA1 can be maintained for more than 1ms.

FIG. 12 shows a flowchart of a process 1200 of monitoring the turn-off function of the second group of power devices during a period in which the main circuit current is alternating current and flows in the first direction, according to some embodiments of the present disclosure. The process 1200 may be performed by the monitoring apparatus 120 or the controller 123. The process 1200 is similar to the process 600 except that a predetermined phase angle needs to be selected in order to select an appropriate second time period t2. Hereinafter, the difference between the process 1200 and the process 600 will be mainly described, and the same parts will not be repeated here.

At block 1210, a second predetermined phase angle is selected, and the second predetermined phase angle corresponds to the second time period t2. In some embodiments, the second predetermined phase angle may be selected within a range of π to 2π. In other embodiments, the second predetermined phase angle may be selected within a range of (36/25) * π to (73/50) * π.

At block 1201, during a period in which the main circuit current (AC) flows from the source S to the drain D of the second group of power devices 112 in the first direction X1, the second turn-off voltage is applied to the gate G of each power device of the second group of power devices 112 in the second time period t2 corresponding to the second predetermined phase angle, so as to turn off the second group of power devices 112 in this time period.

The process shown in blocks 1202 to 1209 is similar to the process of blocks 620 to 690 described in conjunction with FIG. 6, which will not be repeated here.

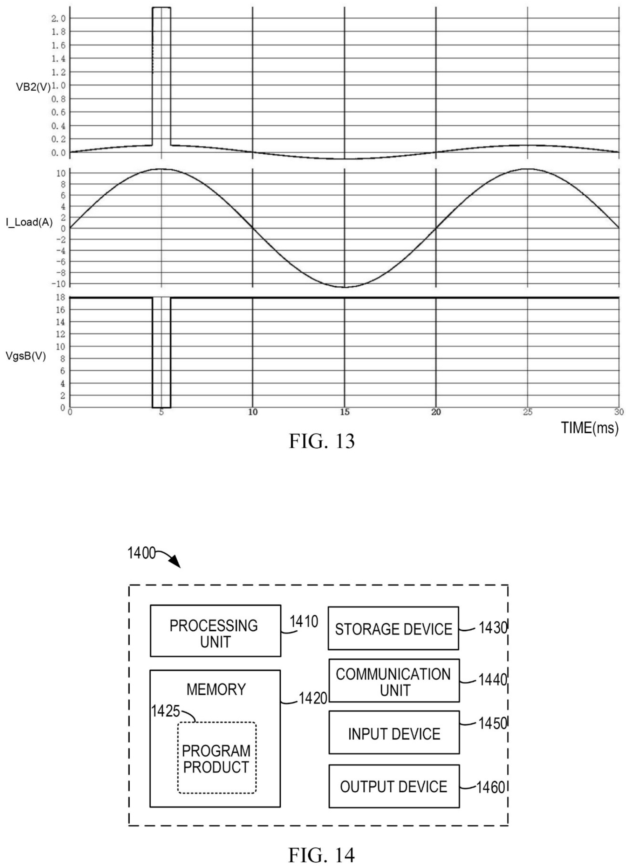

FIG. 13 shows a timing diagram of various signals in a case where the second turn-off voltage is applied to the second group of power devices during a period in which the main circuit current is alternating current and flows in the first direction, according to some embodiments of the present disclosure. The shown signals include the drive voltage VgsB applied to the gate G of the second group of power devices 112, the main circuit current I_Load, and the voltage VB2 between the fourth node NS2 and the third node ND2.

As shown in FIG. 13, in a case where the drive voltage VgsB is changed to the second turn-off voltage (for example, drops to 0V) in the second time period t2 corresponding to the second predetermined phase angle, the main circuit current I_Load is not affected, and thus the normal operation of the load is not affected. The voltage VB2 may rise significantly in the case where the drive voltage VgsB is changed to the second turn-off voltage, and a lasting time of the rising voltage VB2 substantially corresponds to the second time period t2. A relatively long turn-off time of the second group of power devices 112 facilitates capturing the change of the voltage VB2.

The process of monitoring the turn-off function of the first group of power devices 111 during a period in which the main circuit current is alternating current and flows in the second direction X2 is similar to the process 1200 of monitoring the turn-off function of the second group of power devices 112 during the period in which the main circuit current is alternating current and flows in the first direction X1. For example, in a case where the main circuit current is alternating current and flows through the first group of power devices 111 in the second direction X2, in order to monitor whether the turn-off function of the first group of power devices 111 is normal, the first turn-off voltage may be applied to the gate G of each power device of the first group of power devices 111 in the third time period t3 corresponding to the third predetermined phase angle. In response to the application of the first turn-off voltage, the voltage VA2 between the first node ND1 and the second node NS1 may be obtained. Then, it may be determined, based on the voltage VA2 between the first node ND1 and the second node NS1, whether the turn-off function of each power device of the first group of power devices 111 is normal when the main circuit current flows therethrough in the second direction X2. The selection of the third predetermined phase angle may be similarly to that of the second predetermined phase angle.

The process of monitoring the turn-off function of the second group of power devices 112 during a period in which the main circuit current is alternating current and flows in the second direction X2 is similar to the process 1000 of monitoring the turn-off function of the first group of power devices 111 during the period in which the main circuit current is alternating current and flows in the first direction X1. For example, in a case where the main circuit current is alternating current and flows through the second group of power devices 112 in the second direction X2, in order to monitor whether the turn-off function of the second group of power devices 112 is normal, the second turn-off voltage may be applied to the gate G of each power device of the second group of power devices 112 in the fourth time period t4 corresponding to the fourth predetermined phase angle. In response to the application of the second turn-off voltage, the voltage VB1 across the second capacitive element C2 may be obtained. Then, based on the voltage VB1 across the second capacitive element C2, it can be determined whether the turn-off function of each power device of the second group of power devices 112 is normal when the main circuit current flows therethrough in the second direction X2. The selection of the fourth predetermined phase angle may be similarly to that of the first predetermined phase angle.

According to embodiments of the present disclosure, it is possible to monitor whether the switching unit can be normally turned off during operation of the solid-state circuit breaker without shutting down the solid-state circuit breaker, thereby avoiding a situation that the switching unit cannot be turned off when a short circuit occurs in the main circuit due to failure of the power device.

FIG. 14 shows a block diagram of an electronic device 1400 capable of implementing one or more embodiments of the present disclosure. It should be understood that the electronic device 1400 shown in FIG. 14 is merely illustrative and should not constitute any limitation on the functionality and scope of embodiments described herein. The electronic device 1400 shown in FIG. 14 may be used to implement at least a part of the present disclosure.

As shown in FIG. 14, the electronic device 1400 is in the form of a general-purpose electronic device. Components of the electronic device 1400 may include, but are not limited to, one or more processors or processing units 1410, a memory 1420, a storage device 1430, one or more communication units 1440, one or more input devices 1450, and one or more output devices 1460. The processing unit 1410 may be an actual or virtual processor and capable of performing various processes according to programs stored in the memory 1420. In multiprocessor systems, multiple processing units execute computer-executable instructions in parallel to improve parallel processing capabilities of electronic device 1400.

The electronic device 1400 typically includes a plurality of computer storage media. Such media may be any available media accessible to the electronic device 1400, including, but not limited to, volatile and non-volatile media, removable and non-removable media. The memory 1420 may be volatile memory (e.g., registers, caches, random access memory (RAM)), non-volatile memory (e.g., read-only memory (ROM), electrically erasable programmable read-only memory (EEPROM), flash memory), or a combination thereof. The storage device 1430 may be a removable or non-removable medium and may include a machine-readable medium, such as a flash drive, magnetic disk, or any other medium, which may be capable of storing information and/or data (e.g., training data for training) and may be accessed within electronic device 1400.

The electronic device 1400 may further include additional removable/non-removable, volatile/non-volatile storage media. Although not shown in FIG. 14, a disk drive for reading from or writing into a removable, nonvolatile magnetic disk (e.g., a "floppy disk") and an optical disk drive for reading from or writing into a removable, nonvolatile optical disk may be provided. In these cases, each drive may be electrically connected to a bus (not shown) by one or more data media interfaces. The memory 1420 may include a computer program product 1425 having one or more program modules configured to perform various methods or acts of various embodiments of the present disclosure.

The communication unit 1440 is configured to communicate with another electronic device through a communication medium. Additionally, the functions of components of the electronic device 1400 may be implemented in a single computing cluster or multiple computing machines capable of communicating with each other via a communication connection. Thus, the electronic device 1400 may operate in a networked environment using logical connections with one or more other servers, network personal computers (PCs), or another network node.

The input device 1450 may be one or more input devices, such as a mouse, a keyboard, a trackball, or the like. The output device 1460 may be one or more output devices, such as a display, a speaker, a printer, or the like. The electronic device 1400 may also communicate with one or more external devices (not shown) through the communication unit 1440 as needed. The external devices, such as storage devices, display devices, etc., communicate with one or more devices that enable a user to interact with the electronic device 1400, or communicate with any device (e.g., a network card, a modem, etc.) that enables the electronic device 1400 to communicate with one or more other electronic devices. Such communication may be performed via an input/output (I/O) interface (not shown).

According to example implementations of the present disclosure, an apparatus for monitoring a switching unit in a solid-state circuit breaker is provided. The apparatus includes at least one processing unit and at least one memory. The at least one memory is coupled to the at least one processing unit and stores instructions for execution by the at least one processing unit, the instructions, when executed by the at least one processing unit, cause the apparatus to perform methods described above.

According to example implementations of the present disclosure, a solid-state circuit breaker is provided. The solid-state circuit breaker includes a switching unit, a first capacitive element and a first resistive element, a second capacitive element and a second resistive element, a shunt resistor, and a processing unit. The switching unit includes a first group of power devices and a second group of power devices. A first electrode of each power device of the first group of power devices is electrically connected to a first node, a second electrode of each power device of the first group of power devices is electrically connected to a second node, a first electrode of each power device of the second group of power devices is electrically connected to a third node, a second electrode of each power device of the second group of power devices is electrically connected to a fourth node. The fourth node is electrically connected to the second node. The first capacitive element and the first resistive element are connected in series between the first node and the second node. The second capacitive element and the second resistive element are connected in series between the third node and the fourth node. The shunt resistor is connected between the second node and the fourth node. The processing unit is configured to perform methods described above.

According to example implementations of the present disclosure, there is provided a computer-readable storage medium having computer-executable instructions stored thereon, where the computer-executable instructions are executed by a processor to implement methods described above. According to example implementations of the present disclosure, a computer program product is further provided, the computer program product is tangibly stored on a non-transitory computer-readable medium and includes computer-executable instructions, and the computer-executable instructions are executed by a processor to implement methods described above.

Various aspects of the present disclosure are described herein with reference to flowcharts and/or block diagrams of methods, apparatuses, devices, and computer program products implemented in accordance with the present disclosure. It should be understood that each block of the flowchart and/or block diagram, and combinations of blocks in the flowcharts and/or block diagrams, may be implemented by computer readable program instructions.

These computer-readable program instructions may be provided to a processing unit of a general purpose computer, special purpose computer, or other programmable data processing apparatus to produce a machine, such that the instructions, when executed by a processing unit of a computer or other programmable data processing apparatus, produce a device that implements the functions/acts specified in one or more blocks of the flowcharts and/or block diagrams. These computer-readable program instructions may also be stored in a computer-readable storage medium, where the instructions cause the computer, programmable data processing apparatus, and/or other devices to operate in a particular manner. Thus, the computer-readable medium storing instructions includes an article of manufacture including instructions to implement various aspects of the functions/acts specified in one or more blocks of the flowcharts and/or block diagrams.

The computer-readable program instructions may be loaded onto a computer, other programmable data processing apparatus, or other devices, such that a series of operational steps are performed on a computer, other programmable data processing apparatus, or other device to produce a computer-implemented process. Thus, the instructions executed on a computer, other programmable data processing apparatus, or other device implement the functions/acts specified in one or more blocks of the flowcharts and/or block diagrams.

The flowcharts and block diagrams in the figures show architectural frameworks, functions, and operations of possible implementations of systems, methods, and computer program products according to multiple implementations of the present disclosure. In this regard, each block in the flowcharts or block diagrams may represent a module, program segment, or a portion of an instruction that includes one or more executable instructions for implementing the specified logical function. In some alternative implementations, the functions indicated in the blocks may also occur in an order different from that indicated in the figures. For example, two consecutive blocks may actually be performed substantially in parallel, or they may sometimes be performed in the reverse order, depending on the functionality involved. It is also noted that each block in the block diagrams and/or flowcharts, as well as combinations of blocks in the block diagrams and/or flowcharts, may be implemented by a dedicated hardware-based system that performs the specified functions or actions, or by a combination of dedicated hardware and computer instructions.

Various implementations of the present disclosure have been described above, which are illustrative, not exhaustive, and are not limited to the implementations disclosed. Many modifications and variations will be apparent to those of ordinary skill in the art without departing from the scope of the various implementations illustrated. The selection of the terms used herein is intended to best explain the principles of the various implementations, practical applications, or improvements to technology in the marketplace, or to enable others of ordinary skill in the art to understand the various implementations disclosed herein.

## Claims

1. A method of monitoring a switching unit (110) in a solid-state circuit breaker, the switching unit (110) comprising a first group of power devices (111), a first electrode of each power device of the first group of power devices (111) being electrically connected to a first node (ND1), and a second electrode of each power device of the first group of power devices (111) being electrically connected to a second node (NS1), the method comprising:
during a period in which a main circuit current (I_Load) flows from the first electrode to the second electrode of the first group of power devices (111) in a first direction (X1), causing a first turn-off voltage to be applied to a gate (G) of each power device of the first group of power devices (111) in a first time period (t1);
in response to the application of the first turn-off voltage, obtaining a voltage (VA1) across a first capacitive element (C1), wherein the first capacitive element (C1) and a first resistive element (R1) are connected in series between the first node (ND1) and the second node (NS1); and
based on the voltage (VA1) across the first capacitive element (C1), determining whether a turn-off function of each power device of the first group of power devices (111) is normal when the main circuit current (I_Load) flows therethrough in the first direction (X1).

2. The method of claim 1, wherein determining whether the turn-off function of each power device of the first group of power devices (111) is normal when the main circuit current (I_Load) flows therethrough in the first direction (X1) comprises:
in response to the voltage (VA1) across the first capacitive element (C1) being higher than a first voltage threshold (Vth1) at a predetermined time point or within a predetermined time period after the first turn-off voltage starts to be applied, determining that the turn-off function of each power device of the first group of power devices (111) is normal when the main circuit current (I_Load) flows therethrough in the first direction (X1); and
in response to the voltage (VA1) across the first capacitive element (C1) being lower than the first voltage threshold (Vth1) at the predetermined time point or within the predetermined time period, determining that the turn-off function of at least one power device of the first group of power devices (111) is abnormal when the main circuit current (I_Load) flows therethrough in the first direction (X1).

3. The method of claim 1 or 2, further comprising:
during a period in which a turn-on voltage is applied to the gate (G) of each power device of the first group of power devices (111), obtaining a voltage (VA2) between the first node (ND1) and the second node (NS1);
in response to the voltage (VA2) between the first node (ND1) and the second node (NS1) being within a first predetermined voltage range, determining that a turn-on function of each power device of the first group of power devices (111) is normal; and
in response to the voltage (VA2) between the first node (ND1) and the second node (NS1) being outside the first predetermined voltage range, determining the turn-on function of at least one power device of the first group of power devices (111) is abnormal.

4. The method of claim 1 or 2, further comprising:
during a period in which a turn-on voltage is applied to the gate (G) of each power device of the first group of power devices (111), obtaining a first housing temperature (Tc(A)) of the first group of power devices (111);
in response to the first housing temperature (Tc(A)) being within a first predetermined temperature range, determining that a turn-on function of each power device of the first group of power devices (111) is normal; and
in response to the first housing temperature (Tc(A)) being outside the first predetermined temperature range, determining that the turn-on function of at least one power device of the first group of power devices (111) is abnormal.

5. The method of any of claims 1 to 4, wherein the switching unit (110) further comprises a second group of power devices (112), a first electrode of each power device of the second group of power devices (112) being electrically connected to a third node (ND2), a second electrode of each power device of the second group of power devices (112) being electrically connected to a fourth node (NS2), and the fourth node (NS2) being electrically connected to the second node (NS1),
wherein a second capacitive element (C2) and a second resistive element (R2) are connected in series between the third node (ND2) and the fourth node (NS2), and
wherein the method further comprises:
during a period in which the main circuit current (I_Load) flows from the second electrode to the first electrode of the second group of power devices (112) in the first direction (X1), causing a second turn-off voltage to be applied to a gate (G) of each power device of the second group of power devices (112) in a second time period (t2), wherein a length of the second time period (t2) is greater than that of the first time period (t1);
in response to the application of the second turn-off voltage, obtaining a voltage (VB2) between the fourth node (NS2) and the third node (ND2); and
based on the voltage (VB2) between the fourth node (NS2) and the third node (ND2), determining whether a turn-off function of each power device of the second group of power devices (112) is normal when the main circuit current (I_Load) flows therethrough in the first direction (X1).

6. The method of claim 5, wherein determining whether the turn-off function of each power device of the second group of power devices (112) is normal when the main circuit current (I_Load) flows therethrough in the first direction (X1) comprises:
in response to the voltage (VB2) between the fourth node (NS2) and the third node (ND2) being higher than a second voltage threshold (Vth2) after the second turn-off voltage is applied, determining that the turn-off function of each power device of the second group of power devices (112) is normal when the main circuit current (I_Load) flows therethrough in the first direction (X1); and
in response to the voltage (VB2) between the fourth node (NS2) and the third node (ND2) being lower than the second voltage threshold (Vth2) after the second turn-off voltage is applied, determining that the turn-off function of at least one power device of the second group of power devices (112) is abnormal when the main circuit current (I_Load) flows therethrough in the first direction (X1).

7. The method of claim 6, further comprising:
obtaining a current value (Ishunt) measured by a shunt resistor (RS), the shunt resistor (RS) being electrically connected to the second node (NS1) and the fourth node (NS2);
obtaining a second housing temperature (Tc(B)) of the second group of power devices (112); and
based on the current value (Ishunt) and the second housing temperature (Tc(B)), determining the second voltage threshold (Vth2).

8. The method of any of claims 5 to 7, further comprising:
during a period in which a turn-on voltage is applied to a gate (G) of each power device of the first group of power devices (111) and the second group of power devices (112), obtaining a voltage (VA2) between the first node (ND1) and the second node (NS1) and a voltage (VB2) between the fourth node (NS2) and the third node (ND2);
in response to the voltage (VA2) between the first node (ND1) and the second node (NS1) being within a first predetermined voltage range, determining that a turn-on function of each power device of the first group of power devices (111) is normal;
in response to the voltage (VA2) between the first node (ND1) and the second node (NS1) being outside the first predetermined voltage range, determining that the turn-on function of at least one power device of the first group of power devices (111) is abnormal;
in response to the voltage (VB2) between the fourth node (NS2) and the third node (ND2) being within a second predetermined voltage range, determining that a turn-on function of each power device of the second group of power devices (112) is normal; and
in response to the voltage (VB2) between the fourth node (NS2) and the third node (ND2) being outside the second predetermined voltage range, determining that the turn-on function of at least one power device of the second group of power devices (112) is abnormal.

9. The method of any of claims 5 to 8, further comprising:
during a period in which a turn-on voltage is applied to a gate (G) of each power device of the first group of power devices (111) and the second group of power devices (112), obtaining a first housing temperature (Tc(A)) of the first group of power devices (111) and a second housing temperature (Tc(B)) of the second group of power devices (112);
in response to the first housing temperature (Tc(A)) being within a first predetermined temperature range, determining that a turn-on function of each power device of the first group of power devices (111) is normal;
in response to the first housing temperature (Tc(A)) being outside the first predetermined temperature range, determining that the turn-on function of at least one power device of the first group of power devices (111) is abnormal;
in response to the second housing temperature (Tc(B)) being within a second predetermined temperature range, determining that a turn-on function of each power device of the second group of power devices (112) is normal; and
in response to the second housing temperature (Tc(B)) being outside the second predetermined temperature range, determining that the turn-on function of at least one power device of the second group of power devices (112) is abnormal.

10. The method of claim 5, wherein the main circuit current (I_Load) is alternating current (AC), and the method further comprises:
during a period in which the main circuit current (I_Load) flows from the second electrode to the first electrode of the first group of power devices (111) in a second direction (X2), causing the first turn-off voltage to be applied to the gate (G) of each power device of the first group of power devices (111) in a third time period (t3);
in response to the application of the first turn-off voltage, obtaining a voltage (VA2) between the first node (ND1) and the second node (NS1); and
based on the voltage (VA2) between the first node (ND1) and the second node (NS1), determining whether the turn-off function of each power device of the first group of power devices (111) is normal when the main circuit current (I_Load) flows therethrough in the second direction (X2).

11. The method of claim 10, further comprising:
during a period in which the main circuit current (I_Load) flows from the first electrode to the second electrode of the second group of power devices (112) in the second direction (X2), causing the second turn-off voltage to be applied to the gate (G) of each power device of the second group of power devices (112) in a fourth time period (t4);
in response to the application of the second turn-off voltage, obtaining a voltage (VB1) across the second capacitive element (C2); and
based on the voltage (VB1) across the second capacitive element (C2), determining whether the turn-off function of each power device of the second group of power devices (112) is normal when the main circuit current (I_Load) flows therethrough in the second direction (X2), and optionally,
wherein the first time period (t1) corresponds to a first predetermined phase angle when the main circuit current (I_Load) flows in the first direction (X1), the second time period (t2) corresponds to a second predetermined phase angle when the main circuit current (I_Load) flows in the first direction (X1), the third time period (t3) corresponds to a third predetermined phase angle when the main circuit current (I_Load) flows in the second direction (X2), and the fourth time period (t4) corresponds to a fourth predetermined phase angle when the main circuit current (I_Load) flows in the second direction (X2).

12. The method of any of claims 5 to 11, further comprising:
in response to the turn-off function or the turn-on function of at least one power device of the first group of power devices (111) and the second group of power devices (112) being abnormal, triggering an alarm or causing a mechanical switch of the solid-state circuit breaker to be opened.

13. An apparatus for monitoring a switching unit (110) in a solid-state circuit breaker, comprising:
at least one processing unit (1410); and
at least one memory (1420) coupled to the at least one processing unit (1410) and storing instructions for execution by the at least one processing unit (1410), the instructions, when executed by the at least one processing unit (1410), causing the apparatus to perform the method of any of claims 1-12.

14. A computer-readable storage medium having stored thereon a computer program executable by a processor to implement the method of any of claims 1-12.

15. A solid-state circuit breaker comprising:
a switching unit (110) comprising a first group of power devices (111) and a second group of power devices (112), wherein a first electrode of each power device of the first group of power devices (111) is electrically connected to a first node (ND1), a second electrode of each power device of the first group of power devices (111) is electrically connected to a second node (NS1), a first electrode of each power device of the second group of power devices (112) is electrically connected to a third node (ND2), a second electrode of each power device of the second group of power devices (112) is electrically connected to a fourth node (NS2), and the fourth node (NS2) is electrically connected to the second node (NS1);
a first capacitive element (C1) and a first resistive element (R1) connected in series between the first node (ND1) and the second node (NS1);
a second capacitive element (C2) and a second resistive element (R2) connected in series between the third node (ND2) and the fourth node (NS2);
a shunt resistor (RS) connected between the second node (NS1) and the fourth node (NS2); and
a processing unit (1410) configured to perform the method according to any of claims 1-12.
